Europäisches Patentamt

European Patent Office

Office européen des brevets

(19)

(11) Publication number: **0 138 473**
A2

(12) # EUROPEAN PATENT APPLICATION

(21) Application number: **84306603.6**

(22) Date of filing: **28.09.84**

(51) Int. Cl.⁴: **H 05 K 13/00**

(30) Priority: **28.09.83 US 536599**

(43) Date of publication of application: **24.04.85**
Bulletin 85/17

(84) Designated Contracting States: **DE FR GB**

(71) Applicant: **Hewlett-Packard Company, Mail Stop 20 B-O 3000 Hanover Street, Palo Alto California 94304 (US)**

(72) Inventor: **Thrasher, David Lawrence, 430 O'Connnor, Menlo Park California 94304 (US)**
Inventor: **Tullis, Barclay J., 1795 Guinda Street, Palo Alto California 94303 (US)**
Inventor: **Kaempf, Ulrich, 1094 Eastwood Ct., Los Altos California 94022 (US)**
Inventor: **Jamieson, John, 138 Blossom Glen Way, Los Gatos California 95053 (US)**
Inventor: **Parikh, Mihir, 7174 Wooded Lake Drive, San Jose California 95120 (US)**

(74) Representative: **Oliver, Peter Anthony, Hewlett-Packard Limited Nine Mile Ride Easthampstead, Wokingham, Berkshire RG11 3LL (GB)**

(54) **System for integrated circuit processing.**

(57) A standardized mechanical interface (SMIF) system for processing integrated circuits (IC) is disclosed that reduces particle contamination of IC wafers by as much as ten times over conventional clean room handling practice. The IC wafers are retained within small, clean, still-air enclosures (90, 10) and are handled by mechanical arms (120) without physical intrusion by human operators. The level of SMIF system particle contamination is independent of the outside environment so that ICs can be processed in a non-clean facility.

EP 0 138 473 A2

ACTORUM AG

1
## SYSTEM FOR INTEGRATED CIRCUIT PROCESSING

This invention is concerned with a system for integrated circuit processing.

Processing yield has long been a major concern in integrated circuit (IC) manufacturing. A major cause of IC processing failures is the existence of particles such as dust in the processing environment. Conventional IC processing is therefore done in a clean room in which the air is continuously circulated and filtered in an attempt to remove the airborne particles. In addition, personnel are usually clothed in special suits in an attempt to reduce the number of particles introduced as the workers move about the clean room. As a final step, many of the most vulnerable IC process steps are further contained beneath laminar flow down-drafts of filtered air to provide added protection from local sources of particulate contamination.

Unfortunately such an environment suffers from several disadvantages. Firstly, such specially designed rooms are not only fairly expensive to construct and maintain, but also working in such an environment is inconvenient. Secondly, since the size of particles which will cause product failure is usually equal to or greater than 1/4 to 1/3 the minimum feature size of the product, it is necessary to continually reduce contamination levels as dimensions are reduced in newer IC products in order to maintain acceptable

2          0138473

process yields. This problem becomes especially acute as the minimum feature size drops below one micron for very large scale integrated (VLSI) ICs.

The present invention provides a system suitable for processing integrated circuits, characterized by first enclosure means arranged to substantially surround or enclose at least a work station or part of a piece of integrated circuit processing equipment to provide a still-air environment, second enclosure means for transporting integrated circuits in a still-air environment, and interface means for coupling said first and second enclosure means together to prevent the intrusion of particle contamination from the air outside of the first and second enclosures.

A system as set forth in the last preceding paragraph may further comprise manipulator means coupled to the first enclosure means for moving the integrated circuits within the first enclosure means.

A system as set forth in the last preceding paragraph may be further characterized in that said manipulator means further comprises an arm passing through an opening in the first enclosure means, and bearing means coupled to the first enclosure means and the arm for sealing said opening against the intrusion of particles.

A system as set forth in the last preceding paragraph may be further characterized by damping means coupled between said arm and said first enclosure means for limiting the rate at which said arm can move.

A system as set forth in any one of the last three immediately preceding paragraphs may be further characterized in that said manipulator means comprises an air-tight glove.

A system as set forth in any one of the last five immediately preceding paragraphs may be further characterized by a cassette for carrying integrated circuits.

A system as set forth in the last preceding paragraph may be further characterized by retaining means for holding the integrated circuits within said cassette.

A system as set forth in either one of the last two immediately preceding paragraphs may be further characterized in that gripper means is coupled to said arm for manipulating said cassette.

A system as set forth in any one of the last three immediately preceding paragraphs may be further characterized by cassette storage means for storing a cassette in still-air environment.

A system as set forth in any one of the last nine immediately preceding paragraphs may be further characterized by means for transporting integrated circuits between the first and second enclosure means.

A system as set forth in any one of the last ten immediately preceding paragraphs may be further characterized by box storage means for storing one or more second enclosure means.

A system as set forth in any one of the last eleven immediately preceding paragraphs may be further characterized by alignment means for orienting the second enclosure means relative to the first enclosure means.

A system as set forth in the last preceding paragraph may be further characterized by clamping means for holding said first and second enclosure means in said alignment means.

A system as set forth in any one of the last thirteen immediately preceding paragraphs may be further characterized by particle-filter openings in said first and second enclosure means to allow continuous equalization between internal and external air pressure of each of said first and second enclosure means.

A system as set forth in any one of the last fourteen immediately preceding paragraphs may be further characterized by air filtration means coupled to the first enclosure

4 0138473

means for removing particles from said first enclosure means.

A system as set forth in any one of the last fifteen immediately preceding paragraphs may be further characterized by means coupled to the first enclosure means for directly holding integrated circuits.

A system as set forth in any one of the last sixteen immediately preceding paragraphs may be further characterzed in that said interface means comprises first and second closure means arranged to mate one with the other and for independently sealing the first and second enclosure means respectively from particle contamination as aforesaid.

A system as set forth in any one of the last seventeen immediately preceding paragraphs may be further characterized by interlock means for moving integrated circuits from a particle contaminated environment into said second enclosure means without introducing particle contamination into the second enclosure means.

A system as set forth in the last preceding paragraph may be further characterized in that said interlock means comprises a main chamber, an access chamber for receiving the integrated circuits from the contaminated environment, an air-tight closure between the main chamber and the access chamber, second interface means for coupling said main chamber and said second enclosure means while substantially excluding the intrusion of particle contamination from air outside of the main chamber and the second enclosure means, and air filtration means coupled to the main chamber for removing particles from said main chamber introduced when said air-tight door is opened.

A system as set forth in the last preceding paragraph may be further characterized in that manipulator means is provided in the main chamber and sealed against the intrusion of particle contamination from air outside of the main chamber for manually manipulating the integrated circuits within the main chamber.

The present invention is a departure from the use of a conventional clean room in the fabrication of ICs. Instead, a novel standardized mechanical interface (SMIF) system is utilized that reduces particle contamination by significantly reducing particle fluxes onto wafers. This is done by mechanically assuring that during transportation, storage, and most processing steps, the gaseous media surrounding the wafers is essentially stationary relative to the wafers, and that particles from exterior "ambient" environments cannot enter the wafer environments. Experiments have shown that the SMIF system of wafer handling reduces wafer particle contamination by as much as ten times when compared to conventional Class 100 clean room wafer handling practice. In addition, since the level of SMIF system particle contamination is independent of the ambient external environment, IC manufacturing can proceed in a non-clean facility. Thus, not only is the expense and inconvenience of a clean room eliminated, but also process yields can be maintained or even improved for high density VLSI processes due to the lower concentration of particle contamination.

Experiments have shown that a significant number of processing defects in VLSI circuits are caused by particles and that many of these particles are related to material handling by humans even if low-particle clothing is employed. A sitting person with light hand, forearm and head movements even with proper clean-room clothing will emit more than 100,000 particles/minute, all larger than 0.3 microns. The SMIF system therefore consists of two parts: (1) a clean gas filled canopy around the wafer handling apparatus of each piece of processing equipment; and (2) a small, clean, still-gas box to carry wafers from machine to machine. The various pieces of the system are mechanically interfaced without the need of an air-lock by means of unique particle-free dockable doors which consist of a door on each piece of equipment that fit together to trap particles which have accumulated from the dirty ambient environment on the outer surfaces of the doors. Once linked together, the doors are moved as a unit into the clean interior space, thus opening a particle-free interface between the system components. Wafers are then moved through the system by mechanical arms and elevators without human intrusion. The actual wafer movement can also be fully automated through the use of robotic material handlers to further increase productivity. Thus by eliminating human handling of IC wafers and maintaining the wafers in a still-air environment throughout the majority of the IC process, particles are reduced and process yield is increased.

There now follows a detailed description which is to be read with reference to the accompanying drawings of a system according to the present invention; it is to be clearly understood that this system has been selected for description to illustrate the invention by way of example and not by way of limitation.

In the accompanying drawings:-

Figure 1 shows a first SMIF subsystem component, a canopy, according to a preferred embodiment of the present invention;

Figures 2A and 2B show a second SMIF subsystem component, a cassette port, according to a preferred embodiment of the present invention;

Figures 3A, 3B and 3C show three versions of a third SMIF subsystem component, a cassette manipulator, according to a preferred embodiment of the present invention;

Figure 4 shows the canopy interfaced to the cassette port according to a preferred embodiment of the present invention;

Figure 5 shows an alternative embodiment of an interface as shown in Figure 4;

Figure 6 shows a SMIF box storage unit according to a preferred embodiment of the present invention;

Figure 7 shows a cassette storage unit according to a preferred embodiment of the present invention; and

Figure 8 shows a system interlock according to a preferred embodiment of the present invention.

Conceptually, the SMIF system has two parts:

1) a clean air canopy around the wafer handling apparatus of each piece of processing equipment; and

2) a small clean air box to carry wafers from machine to machine.

In practice, the SMIF system is built from several of the small clean air boxes and canopies to form SMIF subsystems, each of which is built from three SMIF subsystem components.

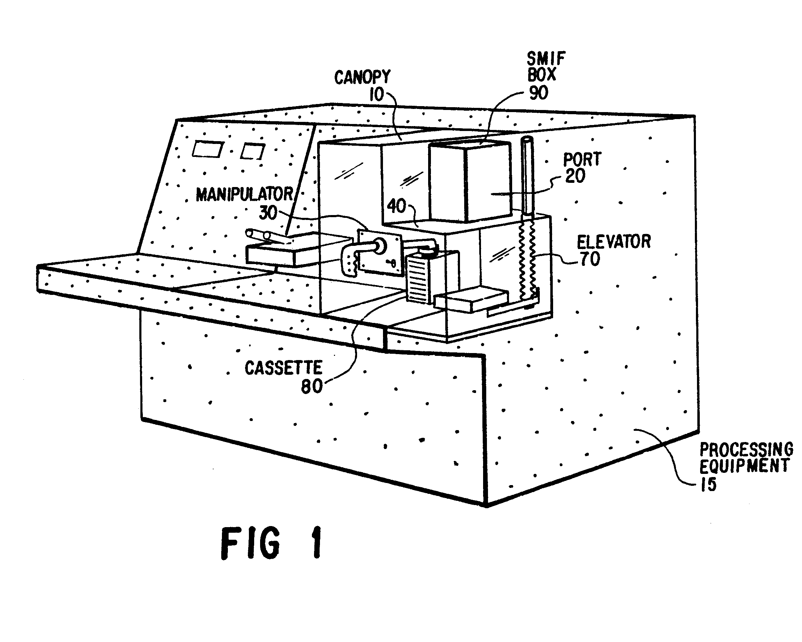

The first SMIF subsystem component as shown in Figure 1 is first enclosure means in the form of the canopy 10. The canopy 10 is an easily removable shield that covers the wafer handling mechanisms of each piece of processing equipment 15 (e.g., photoresist applicators, mask aligners, inspection equipment, etc.). Generally, the canopy 10 is constructed of transparent plastics material such as Lexan to facilitate inspection and/or maintenance within the canopy 10 which may later become necessary. The other subsystem components are a SMIF cassette port 20 and a SMIF cassette manipulator 30 which are bolted onto the canopy 10 in locations that allow easy movement within the canopy 10. Because the canopy 10 encloses the handling mechanisms of the processing equipment 15, there is no need to enclose the processing equipment 15 within a clean room.

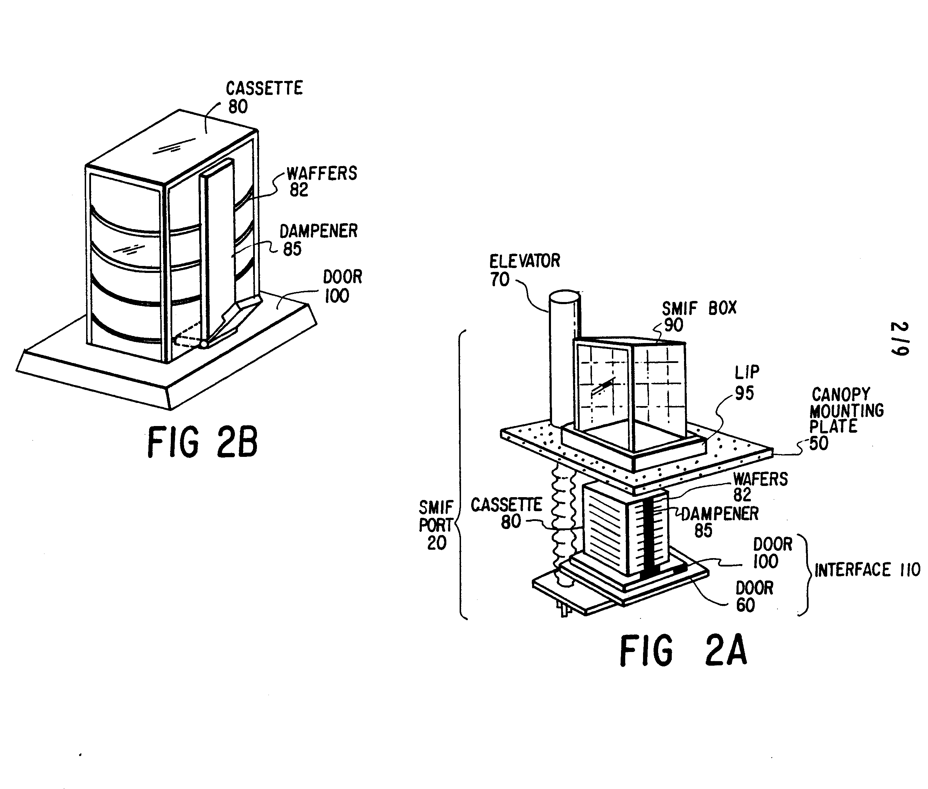

Figure 2A shows the details of the SMIF cassette port 20. The port 20 is typically mounted on a horizontal surface 40 of the canopy 10 by means of a canopy mounting plate 50. The port 20 further consists of a first closure means provided by a port door 60 and an elevator mechanism 70 that transports a cassette 80 containing IC wafers 82 into the interior of the canopy 10. The wafers 82 are held in the cassette 80 by a wafer dampener 85 as shown in Figure 2B which is mounted on a second closure means door 100 and is activated by the weight of the cassette 80.

A SMIF box 90, which is used for transporting cassettes 80 from one piece of processing equipment 15 to another, interfaces with the canopy 10 via the SMIF port 20. The SMIF box 90 is aligned with the SMIF port 20 by means of a wedge-shaped lip 95 and has a door 100 which interlocks with the door 60 on the port 20. Doors 60 and 100 together provide a particle-free dockable interface 110, shown in Figure 2A in the open position, which will be described in detail below. The interface 110 also provides means to latch the box 90 to the port 20 so that the elevator mechanism 70 can freely transport the cassette 80 between the box 90 and the canopy 10. The doors 60 and 100 are designed so that the majority of particles on the exterior surfaces of the doors 60 and 100 are trapped between the doors 60 and 100. Thus, the wafers carried in the cassette 80 are not contaminated when the interface 110 is opened.

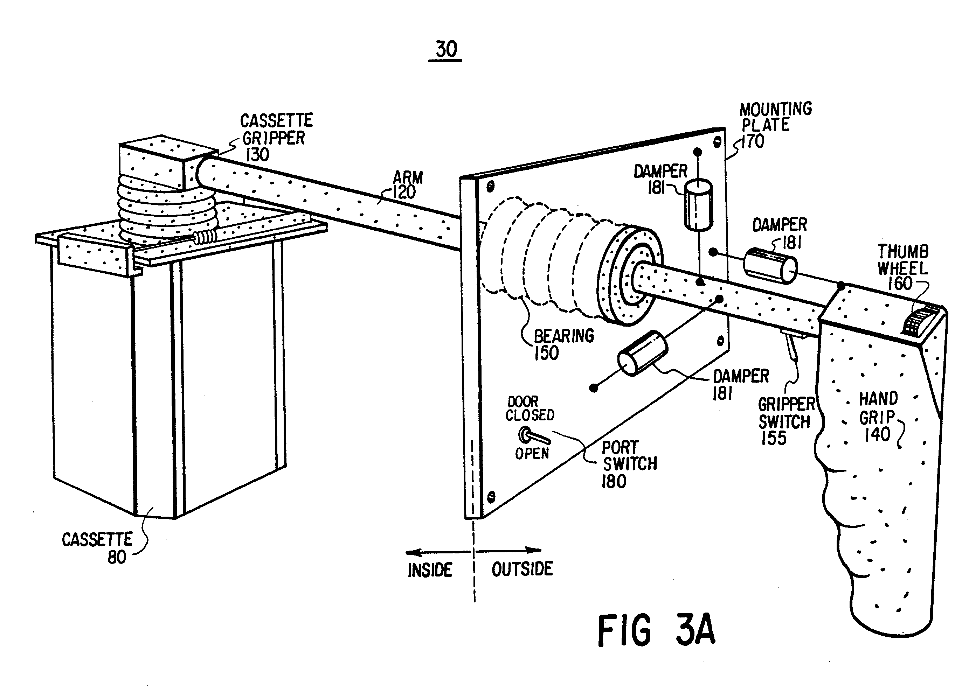

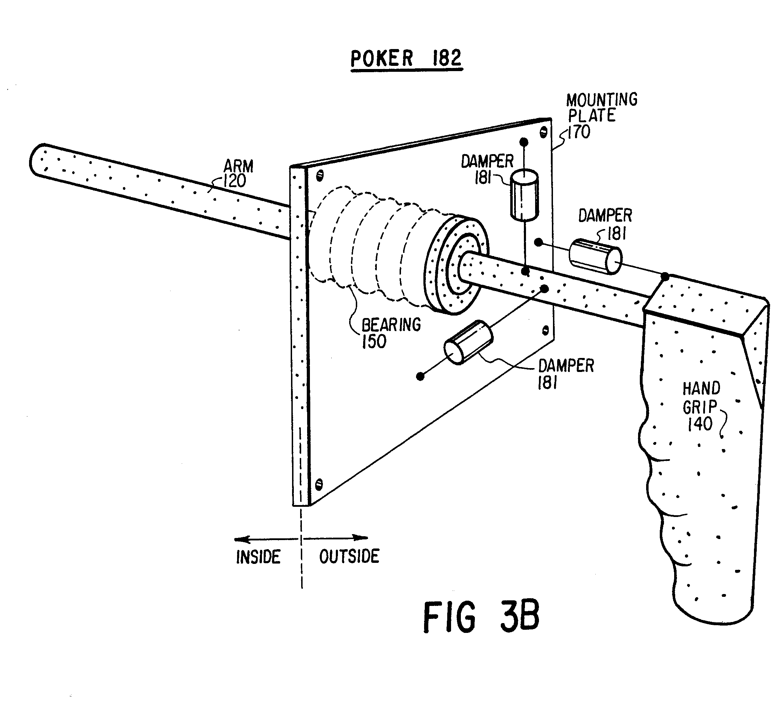

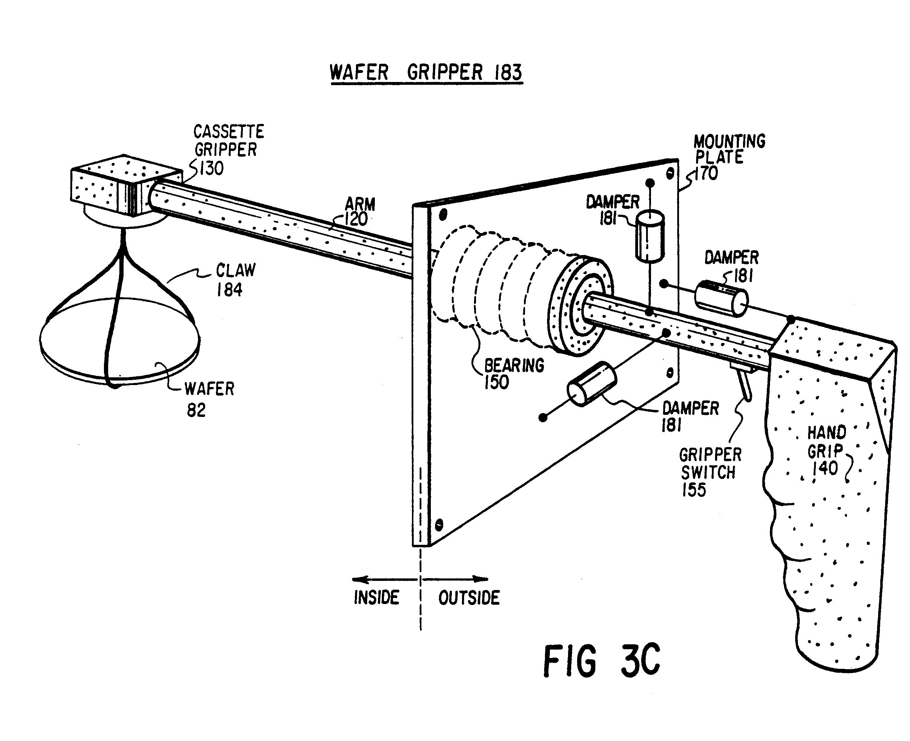

Once the cassette 80 is within the canopy 10, the cassette 80 can be manoeuvred as needed by the cassette manipulator 30. A manually operable cassette manipulator 30 is shown in Figure 3A. The manipulator 30 typically has an arm 120 which is 60-90 cms long and extends through an opening in a front wall of the canopy 10. The arm 120 has a cassette gripper 130 mounted on its inside (clean air) end portion and a hand grip 140 on its outside (ambient) end portion. A bearing 150 provides angular and in-out movement for the arm 120 as well as providing an air seal to prevent the intrusion of dirty ambient air. The cassette gripper 130 is actuated by a gripper switch 155 to hold the cassette 80 which can then be rotated about the vertical axis by a thumb wheel 160 mounted on the hand grip 140 and coupled to the cassette gripper 130. A manipulator mounting plate 170 supports the bearing 150 and a port actuation switch 180 which actuates the latching of doors 60 and 100 and the movement of the elevator mechanism 70.  Mechanical dampers 181 are provided along the three axes of motion of the arm 120 to limit the speed of movement of the gripper 130.  The manipulator mounting plate 170 is bolted to the canopy 10 as shown in Figure 1.  Two alternatives of the cassette manipulator 30 which are often useful are a poker 182 as shown in Figure 3B and a wafer gripper 183 as shown in Figure 3C.  The poker 182 is a cassette manipulator 30 without a gripper 130 and is used to push objects within the canopy 10.  The wafer gripper 183 is a cassette manipulator 30 with a three-pronged claw 184 or similar mechanism replacing the cassette gripper 130 so that the wafers can be grasped directly as needed.  An alternative manipulator may be provided by an air-tight glove.

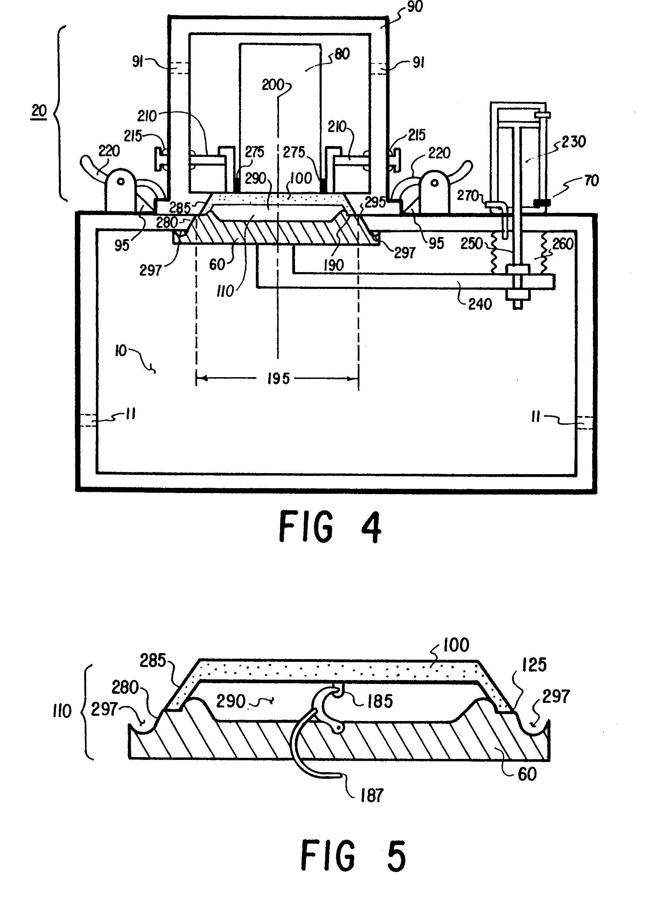

It should be noted that both the canopy 10 and SMIF box 90 described above totally exclude humans and do not utilize constantly moving filtered air to decrease particles on the IC wafer surfaces.  Rather, IC cleanliness is achieved by maintaining a still-air interior environment.  The canopy 10 and the box 90 can each be equipped with particle-filtered openings 11 and 91 respectively, (see Figure 4) to allow continuous equalization between internal and external (ambient) air pressures.  Such filtered pressure equalization openings 11 and 91 minimize pressure difference and air flow between the canopy 10 and the box 90 as the interface 110 is opened and the wafers are moved from the box 90 into the canopy 10.  In addition, access to the interiors of the canopy 10 and box 90 is by means of mechanical arms which occupy essentially constant volume within the enclosures so that there is no significant change in interior volume as IC wafers are moved about.  Hence, since there is little or no change of interior air pressure during processing, there is no need for air-tight seals on the canopy 10 or box 90, and

0138473

particles on the IC wafer surfaces are further decreased by inhibiting the movement of air.

Figure 4 shows a vertically-openable version of the SMIF cassette port 20. A horizontally-openable version is also easily achieved by slight mechanical modifications to the vertically-openable version to include a positive spring loaded latch 185 and release cable 187 as shown in Figure 5 between the doors 60 and 100 since gravity cannot be used to hold the doors together. The cassette box 90 is designed to contain one cassette 80 and is only slightly larger than the cassette 80 itself, which holds the IC wafers. The cassette box 90 will generally have transparent walls to facilitate observations by humans which may be necessary. The particle-free dockable interface 110 mentioned earlier permits clean, particle-free access between two otherwise independent clean environmental systems such as the canopy 10 and the SMIF box 90. The interface 110 avoids letting air-borne particles, especially those in the size range between 0.1 to 20 microns, from entering the otherwise clean equipment containers.

Figure 4 shows the interconnection of the envelopes of the closed spaces defined by the canopy 10 and the cassette box 90 along a contact area 190. In the present invention it is necessary to open the contact area 190 without exposing these spaces to the external environment or to the previously external surfaces of the doors 60 and 100 to these spaces. In particular, when the doors 60 and 100 are opened, the portions of the external surfaces of the contact area 190 lying within the contact opening 195 are made to contact one another thereby trapping particles which may exit on the external surfaces between the doors 60 and 100. The contact area 190 is then kept in contact while the doors 60 and 100 are moved as a single unit into the space defined by the canopy 10.

The doors 60 and 100 are either circularly or rectangularly symmetrical about an axis 200. Before the interface 110 is opened, the door 100 is held in place by latches 210 which pass through the walls of the box 90 by means of airtight bearings or bushings 215. The canopy 10 and the box 90 are held together in the lip 95 by a clamp 220. In the specific embodiment shown in Figure 4, a piston 230 of the elevator mechanism 70 is located outside the canopy 10 and the box 90 to conserve space within the enclosures. The piston 230 is coupled to the door 60 by an arm 240 and a rod 250 secured thereto. The rod 250 passes through the wall of the canopy 10 and a bellows 260 around the lower portion of the lower portion of the rod prevents the intrusion of dirty ambient air. A vent 270 is provided to allow the equalization of air pressure inside of the bellows 260 as the elevator 70 moves and the bellows 260 expands or contracts. Note that the air passing through the vent 270 is dirty ambient air, but this does not contaminate the interior of the canopy 10 because the bellows is sealed to the inside of the canopy 10 and to the arm 250. To open the interface 110, the latches 210 are released, the piston 230 is extended, and the elevator 70 transports both doors 60 and 100 as a unit into the interior of the canopy 10, thereby carrying the cassette 80 aligned with the aid of guide lips 275 into the interior while trapping surface particles between the two doors 60 and 100 and preventing the intrusion of dirty ambient air.

In order to trap surface particles between the doors 60 and 100 it is only necessary that the doors contact each other uniformly and closely around their outer perimeters 280 and 285 respectively. The doors 60 and 100 need not fit flush with each other along the entire interface 110. In fact, it is desirable that an air gap 290 inside of the outer perimeters 280 and 285 be left between the doors 60 and 100. The air gap 290 provides a compressive air space between the doors 60 and 100 so that the dirty air trapped between the doors 60 and 100 does not rush out at high velocity in the plane perpendicular to axis 200 as the doors 60 and 100 are brought together, thereby potentially sweeping part of the dirty trapped air into the interior of the canopy 10 or the box 90. The air gap 290 also prevents doors 60 and 100 from becoming affixed together by air pressure as could occur if the contact area 190 was a large, closely fitting surface. Typically the air gap 290 will occupy more than 80% of the contact opening 195.

Ideally, the doors 60 and 100 should fit together so that perimeters 280 and 285 form one continuous surface. Therefore, joggle 295 where perimeters 280 and 285 meet should be kept as small as possible (e.g., less than .254 - .508 mm) since particles on the joggle 295 will be carried into the interiors of the canopy 10 and the box 90 when the interface 110 is opened. Some particles may be present on the perimeters 280 and 285 so a particle gutter 297 is provided on the door 60 to catch any particles which might roll down the perimeters 280 and 285 when the interface 110 is opened. Alternatively, the particle gutter 297 can be omitted to permit any particles from the perimeters 280 and 285 to settle all the way to the bottom of the canopy 10.

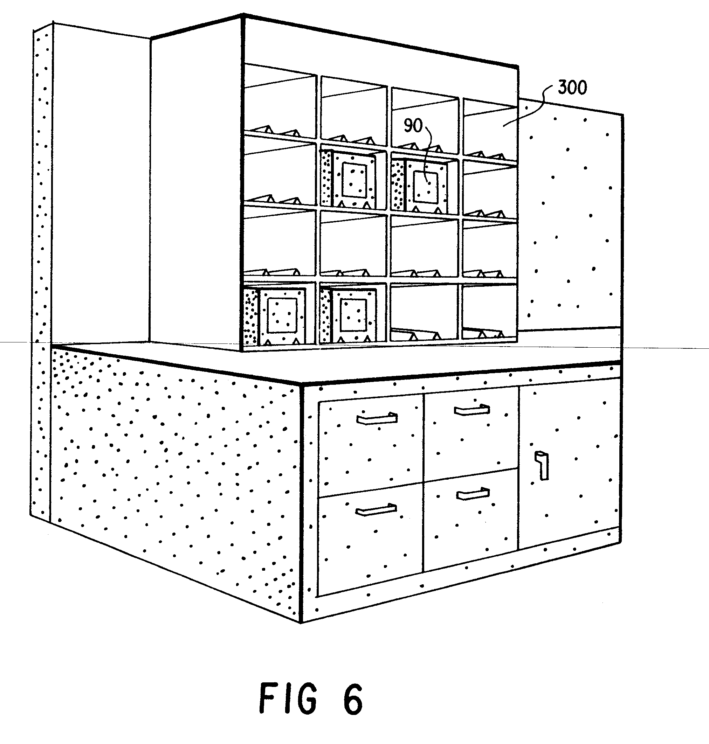

Figure 6 shows a SMIF box storage unit 300. The box storage unit 300 is basically an open rack for storing cassette boxes 90.

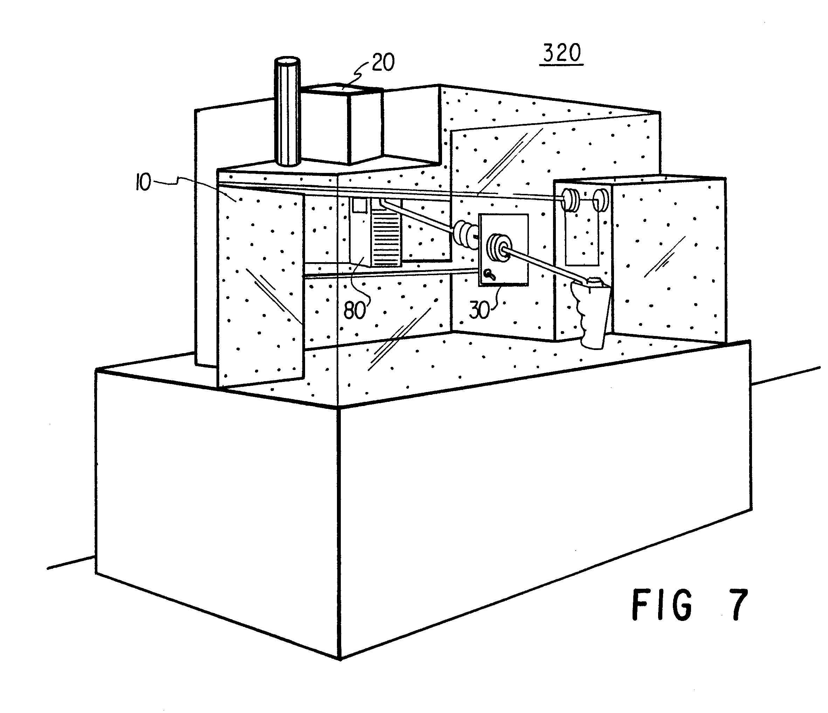

Figure 7 shows a cassette storage unit 320 for storing cassettes 80 holding IC wafers. The cassette storage unit 320 is a desiccator box with a canopy 10, port 20, and manipulator 30 added to it. The cassette storage unit 320 will typically function as a cassette processing buffer.

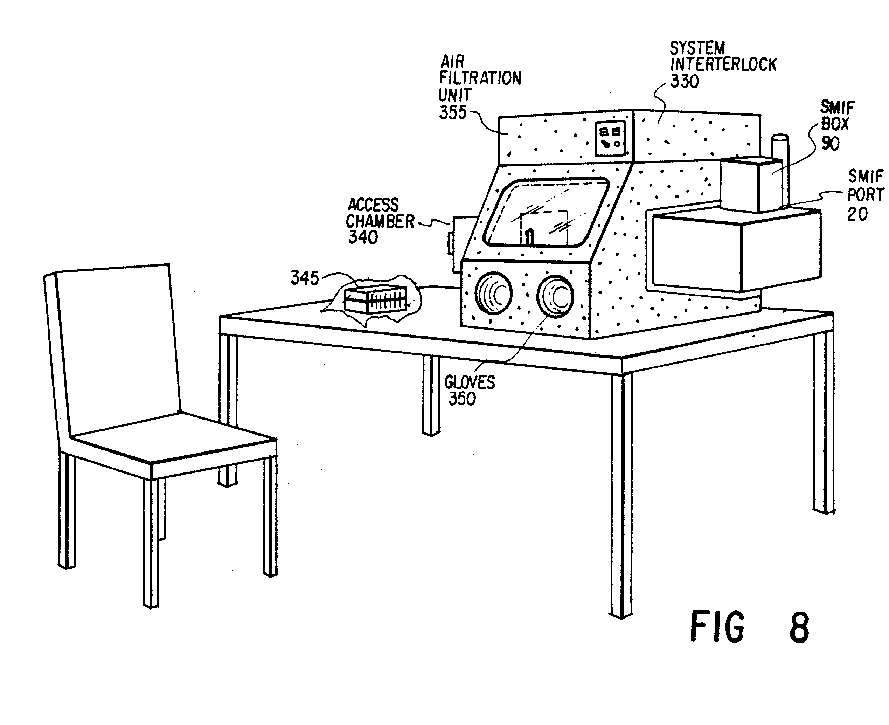

Initial cassette entry into the SMIF system occurs through the system interlock 330 as shown in Figure 8. This is typically a 120 cm wide glove box defining a main chamber 335 with an access chamber 340 at one end and a SMIF port 20 at the other end. The complex movements required to transfer wafers from a new wafer package 345 into a cassette (not shown) necessitates the use of gloves 350 rather than mechanisms. Cassettes 80 and wafers enter and leave the SMIF system through the access chamber 340. Note that since the internal pressure of the system interlock 330 can change abruptly as human arms are thrust in and out of the gloves 350, it is necessary that the system interlock 330 be tightly constructed to prevent the intrusion of outside unfiltered air and it is also necessary to utilize an air filtration unit 355 on the system interlock 330. The air filtration unit 355 can contain both a conventional forced air filter and/or a particle collector such as an electrostatic precipitator. Although generally less desirable from a particle contamination standpoint than using mechanical manipulators 30 on the canopy 10 as shown in Figure 1, gloves 350 could be used to provide further flexibility of motion within canopy 10. Such gloves 350 are especially useful to provide maintenance within canopy 10 during periods when no IC wafers are present which can be contaminated by the intrusion of outside unfiltered air caused by use of the gloves 350. Filtration units 355 could also be used on the canopy 10 during such maintenance periods to remove any particles which may have intruded.

Because ICs are transported in their own closed containers and handling is done by mechanical arms it is also possible to fully automate the IC production facility by the use of stationary or mobile robots which use computer controlled robotic manipulators coupled to the SMIF components. Whether handling is done manually or automatically, by combining the SMIF components with conventional IC processing equipment the IC fabrication area can for the first time be constructed without the need of a conventional clean room environment, while at the same time improving IC cleanliness.

CLAIMS

1. A system suitable for processing integrated circuits, characterized by:

first enclosure means (10) arranged to substantially surround or enclose at least a work station or part of a piece of integrated circuit processing equipment to provide a still-air environment;

second enclosure means (90) for transporting integrated circuits in a still-air environment; and

interface means (110) for coupling said first and second enclosure means together to prevent the intrusion of particle contamination from the air outside of the first and second enclosures.

2. A system according to claim 1 further characterized by:-

manipulator means (30) coupled to the first enclosure means for moving the integrated circuits within the first enclosure means.

3. A system according to claim 2 characterized in that said manipulator means (30) further comprises:

an arm (120) passing through an opening in the first enclosure means; and

bearing means (150) coupled to the first enclosure means and the arm for sealing said opening against the intrusion of particles.

4. A system according to claim 3 further characterized by:-

damping means (181) coupled between said arm (120) and said first enclosure means (10) for limiting the rate at which said arm can move.

0138473

5. A system according to any one of claims 2 to 4 characterized in that said manipulator means comprises an air-tight glove.

6. A system according to any one of the preceding claims further characterized by a cassette (80) for carrying integrated circuits.

7. A system according to claim 6 further characterized by retaining means (85) for holding the integrated circuits within said cassette.

8. A system according to either one of claims 6 and 7 characterized in that gripper means (130) is coupled to said arm for manipulating said cassette.

9. A systen according to any one of claims 6 to 8 further characterized by cassette storage means (320) for storing a cassette in a still-air environment.

10. A system according to any of the preceding claims further characterized by means (70) for transporting integrated circuits between the first and second enclosure means.

11. A system according to any of of the preceding claims further characterized by box storage means (300) for storing one or more second enclosure means.

12. A system according to any one of the preceding claims further characterized by alignment means for orienting the second enclosure means relative to the first enclosure means.

13.    A system according to claim 12 further characterized by clamping means (220) for holding said first and second enclosure means in said alignment means.

14.    A system according to any one of the preceding claims further characterized by particle-filter openings (11, 91) in said first and second enclosure means to allow continuous equalization between internal and external air pressure of each of said first and second enclosure means.

15.    A system according to any of the preceding claims further characterized by air filtration means coupled to the first enclosure means for removing particles from said first enclosure means.

16.    A system according to any one of the preceding claims further characterized by means (183) coupled to the first enclosure means for directly holding integrated circuits.

17.    A system according to any one of the preceding claims characterized in that said interface means comprises first and second closure means (60, 100) arranged to mate one with the other and for independently sealing the first and second enclosure means respectively from particle contamination as aforesaid.

18.    A system according to any one of the preceding claims further characterized by interlock means (330) for moving integrated circuits from a particle contaminated environment into said second enclosure means without introducing particle contamination into the second enclosure means.

19. A system according to claim 18 characterized in that said interlock means (330) comprises:

a main chamber (335);

an access chamber (340) for receiving the integrated circuits from the contaminated environment;

an air-tight closure (341) between the main chamber and the access chamber;

second interface means for coupling said main chamber and said second enclosure means while substantially excluding the intrusion of particle contamination from air outside of the main chamber and the second enclosure means; and

air filtration means (355) coupled to the main chamber for removing particles from said main chamber introduced when said air-tight door is opened.

20. A system according to claim 19 further characterized in that manipulator means (350) is provided in the main chamber and sealed against the intrusion of particle contamination from air outside of the main chamber for manually manipulating the integrated circuits within the main chamber.

FIG 1

CANOPY 10

SMIF BOX 90

MANIPULATOR 30

PORT 20

40

ELEVATOR 70

CASSETTE 80

PROCESSING EQUIPMENT 15

1/9

0138473

CASSETTE 80
WAFFERS 82
DAMPENER 85
DOOR 100

FIG 2B

ELEVATOR 70
SMIF BOX 90
LIP 95
CANOPY MOUNTING PLATE 50
WAFERS 82
DAMPENER 85
CASSETTE 80
DOOR 100
DOOR 60
INTERFACE 110
SMIF PORT 20

FIG 2A

2/9

0138473

FIG 3A

30

CASSETTE GRIPPER 130

ARM 120

MOUNTING PLATE 170

DAMPER 181

DAMPER 181

THUMB WHEEL 160

BEARING 150

DAMPER 181

GRIPPER SWITCH 155

HAND GRIP 140

DOOR CLOSED

OPEN

PORT SWITCH 180

CASSETTE 80

INSIDE    OUTSIDE

3/9

0138473

POKER 182

FIG 3B

WAFER GRIPPER 183

CASSETTE GRIPPER 130

ARM 120

CLAW 184

WAFER 82

MOUNTING PLATE 170

DAMPER 181

DAMPER 181

BEARING 150

DAMPER 181

GRIPPER SWITCH 155

HAND GRIP 140

INSIDE  OUTSIDE

FIG 3C

5/9

0138473

FIG 4

FIG 5

0138473

300

90

FIG 6

FIG 7

0138473

FIG 8